# FASCICULE DE BREVET EUROPEEN

(11) **EP 0 876 682 B1**
(45) Date de publication et mention de la délivrance du brevet: **23.10.2002**
(21) Numéro de dépôt: 97901666.4
(22) Date de dépôt: 24.01.1997
(51) Int. Cl.: H01L 35/08, G08B 13/193

(54) **DISPOSITIF DE DETECTION DE RAYONNEMENT THERMIQUE ET APPAREIL DE DETECTION DE PRESENCE A BASE D'UN TEL DISPOSITIF**
VORRICHTUNG ZUR DETEKTIERUNG VON WÄRMESTRAHLUNG UND DAMIT AUSGERÜSTETES ANWESENHEITS-DETEKTIERUNGSGERÄT
HEAT RADIATION DETECTION DEVICE AND PRESENCE DETECTION APPARATUS USING SAME

(30) Priorité: 26.01.1996 LU 88704
(43) Date de publication de la demande: 11.11.1998
(73) Titulaire: COMMUNAUTE EUROPEENNE DE L'ENERGIE ATOMIQUE (EURATOM), L-2920 Luxembourg (LU)
(72) Inventeur: GUILMAIN, Pierre, I-21027 Ispra (IT); THERY, Pierre, F-59650 Villeneuve-d'Ascq (FR); KORN, Christophe, I-21020 Taino (IT)
(74) Mandataire: Joly, Jean-Jacques
(86) Numéro de dépôt international: FR9700142
(87) Numéro de publication internationale: WO97027634

(56) Documents cités:
- DE-A- 1 566 748
- US-A- 5 045 123
- US-A- 5 059 543
- PATENT ABSTRACTS OF JAPAN vol. 8, no. 8 (E-221), 13 Janvier 1984 & JP 58 171873 A (SHOWA DENKO KK), 8 Octobre 1983,

## Description

La présente invention concerne un dispositif de détection de rayonnement thermique et un appareil de détection de présence à base d'un tel dispositif. L'invention peut être utilisée notamment, mais non exclusivement, pour la détection d'une intrusion dans la surveillance de zones de sécurité.

Dans le domaine de la surveillance à haut degré de sécurité, par exemple pour le contrôle de lieux de stockage de matériel nucléaire, il est primordial de contrôler sans faille et sans interruption les objets dans la zone surveillée.

Actuellement, pour assurer la continuité de la connaissance d'un état à surveiller, par exemple une quantité de matière fissile, et pour surveiller une zone de dimension finie, on utilise des systèmes de scellés, électroniques ou non (avec identité et/ou intégrité), des systèmes de surveillance optique (par caméras) et un éventail de détecteurs classiques.

Les systèmes de scellés sont généralement inadéquats par le fait que la plupart ne sont utilisables qu'une seule fois et qu'ils sont incapables de permettre la surveillance à distance.

Au niveau des systèmes de surveillance vidéo, l'investissement important nécessaire, le traitement d'images et de signaux afin de détecter une intrusion et la possibilité d'erreur par une fausse image, font que ces systèmes présentent d'énormes défauts lorsqu'ils sont mis en oeuvre dans des dispositifs de surveillance à haute sécurité.

Dans la plupart des applications en détection, les systèmes de surveillance traditionnels à ultrasons sont utilisés pour la mesure de rayonnement de sources en mouvement. Leur principe est difficilement utilisable pour faire de la surveillance à grande distance tout en permettant des déplacements dans une portion non destinée à être surveillée du même local.

En effet, la surveillance est impossible par des détecteurs à ultrasons dès qu'il y a un quelconque déplacement autour des limites de la zone surveillée puisqu'ils sont basés sur le principe même de déplacement et vibration moléculaire.

De nombreux dispositifs pyroélectriques et à semiconducteurs sont généralement utilisés pour la détection du rayonnement thermique émis par une source en mouvement. Le rayonnement thermique émis variant avec l'émissivité de la surface, ces détecteurs présentent le grand inconvénient d'avoir leur responsivité dépendante de la longueur d'onde. Il est donc nécessaire de choisir le détecteur en fonction de la source à surveiller puisqu'il travaille dans une bande de fréquence étroite. De plus, ces types de détecteurs s'échauffent avec le rayonnement qu'ils reçoivent et nécessitent toujours un système de refroidissement.

On peut donc déduire que tous les systèmes évoqués présentent, au regard d'une application visant la surveillance à haute sécurité sur une zone précise, au moins l'un des inconvénients suivants :
- la responsivité est pratiquement toujours dépendante de la longueur d'onde, ce qui oblige à choisir un détecteur spécifique en fonction de la source à surveiller;
- dans le cas de systèmes à infrarouges ou à ultrasons, on détecte uniquement le mouvement dans le cadre de la détection. Ces systèmes fournissent seulement l'information de détection due au déplacement d'une source de rayonnement thermique dans une zone surveillée, et non pas l'information de présence;
- une lentille optique est généralement utilisée pour focaliser les rayons incidents, donnant lieu à un effet de filtre indésirable ;
- un encapsulage est normalement nécessaire pour éliminer le bruit extérieur résultant de courants de convection :
   - un dispositif de refroidissement est à prévoir dans de nombreux cas ; et
   - avec des systèmes à ultrasons, on ne peut pas focaliser une surveillance sur une zone particulière de dimensions finies sans être perturbé par la circulation de personnes ou d'objets autour des limites de cette zone.

Le document US-A-5 045 123 décrit une thermopile de forme cylindrique s'étendant parallèlement à la lumière incidente à mesurer et agencée de telle façon que sa face cylindrique ne soit pas exposée à cette lumière incidente. La face cylindrique comporte, à proximité d'une face plane de réception de la lumière, des jonctions chaudes et, à proximité de la seconde face plane, des jonctions froides. La thermopile est fixée à un support au niveau de la seconde face plane par l'intermédiaire d'un adhésif conducteur thermique.

Un objet de la présente invention est de prévoir un dispositif de détection de rayonnement thermique qui ne souffre pas des inconvénients précités.

Le dispositif selon l'invention est caractérisé en ce qu'il comprend :
un détecteur ayant un substrat qui comporte, sur une première face, une ou plusieurs jonctions de thermocouple dites "chaudes" destinées à être exposées au rayonnement thermique et une ou plusieurs jonctions de thermocouple dites "froides" destinées à être protégées du rayonnement thermique, le détecteur étant sensible à une différence de température entre jonctions chaudes et froides, et
un concentrateur du type réflecteur, associé audit détecteur pour concentrer sur celui-ci le rayonnement thermique émanant d'une zone spatiale prédéterminée,
et en ce que la deuxième face du substrat, opposée à la première face, est en contact avec une couche de matériau isotherme, s'étendant en regard des jonctions chaudes et froides.

La combinaison d'un concentrateur du type réflecteur avec un détecteur du type précité permet de cerner une zone de surveillance avec précision et de détecter toute modification de l'état de déséquilibre thermique dans la zone surveillée. On remarque que le détecteur répond à une faible différence de température représentative de la différence entre les énergies absorbées et transformées en flux thermique sous les régions exposées et sous les régions non exposées.

Avantageusement, le concentrateur est un réflecteur parabolique.

Dans un mode de réalisation préféré, le détecteur est monté mobile par rapport à un axe du concentrateur pour permettre une adaptation aisée au champ de détection par un simple réglage de position.

Par ailleurs, l'utilisation d'un concentrateur remplace avantageusement l'emploi d'une lentille optique pour focaliser les rayons thermiques incidents, et évite ainsi les pertes par transmission ou par effet capacitif du matériau de la lentille.

Le principe de fonctionnement et la technologie de fabrication du détecteur permettent de se dispenser des problèmes classiques de refroidissement qui requièrent des cryostats ou des dispositifs à effet Peltier coûteux et consommateurs en énergie.

Le détecteur est sensible à tout objet, même de très faible température, émettant par rayonnement thermique dans une bande très large qui s'étend de 0,75 à 1 000 micromètres, soit entre le visible et les micro-ondes. Il permet de fournir une information représentative des variations instantanées de déséquilibre énergétique entre un système et son environnement, et ainsi de fonctionner comme fluxmètre thermique en régime variable.

Dans un mode de réalisation préféré, le détecteur est composé d'au moins une paire d'éléments thermocouple planaires ayant une jonction froide en contact thermique avec une portion protégée du détecteur et au moins une jonction chaude en contact thermique avec une portion exposée du détecteur.

La ou les portions exposées et la ou les portions protégées peuvent constituer une surface active commune du détecteur, en étant respectivement constituées par des éléments de surface sensiblement absorbants et par des éléments de surface sensiblement réfléchissants relativement au rayonnement thermique.

Selon un mode de réalisation ayant une géométrie particulièrement avantageuse, le détecteur comprend une pluralité d'éléments thermocouples montés en série et disposés en plusieurs lignes reliées aux extrémités de manière à former un chemin en méandres, les jonctions froides et chaudes étant disposées en rangées alternées respectives disposées transversalement aux lignes et étant en contact thermique avec un matériau qui présente la surface sensible sous forme de bandes réfléchissantes et absorbantes arrangées en rangées alternées en phase et alignées respectivement avec les jonctions froides et chaudes.

A titre d'exemple, les éléments thermocouples sont réalisés par des éléments alternés de cuivre et de constantan déposés sur un substrat en matériau électriquement isolant, tel que le matériau connu sous la dénomination "Kapton" qui est une marque déposée de la Société Dupont de Nemours, et les éléments thermocouples sont recouverts d'un matériau sensiblement transparent au rayonnement thermique, qui peut être également du Kapton, les portions du matériau recouvrant une jonction froide étant revêtues d'une couche de matériau réfléchissant. Les parties réfléchissantes peuvent être obtenues par un dépôt d'or sur la surface du matériau recouvrant les thermocouples.

Avantageusement, la couche de matériau isotherme est une couche métallique destinée à être mise en contact avec une surface de support mécanique.

L'invention concerne également un appareil de détection de présence comprenant au moins un dispositif de détection de rayonnement thermique du type précité, et un moyen de contrôle recevant le ou les signaux de détection et émettant un signal indicatif d'une présence en fonction du ou des signaux de détection.

D'autres avantages et caractéristiques de l'invention ressortiront à la lecture d'un mode de réalisation préféré, présenté uniquement à titre d'exemple, en référence aux dessins en annexe, dans lesquels :
- la figure 1 est un schéma simplifié d'un ensemble de détection composé d'un détecteur thermique et d'un réflecteur conformément à la présente invention ;
- la figure 2 est une vue en perspective d'un détecteur de rayonnement thermique utilisé dans un mode de réalisation de l'invention mais représenté sous forme simplifiée, notamment en ce qui concerne le nombre d'éléments actifs ;
- la figure 3 est une vue en coupe selon l'axe III-III du détecteur de la figure 2 ;
- la figure 4 est un schéma de principe d'un système de surveillance mettant en oeuvre des ensembles de détection de la figure 1 ; et
- la figure 5 est un exemple de tracé de signal recueilli par le système de surveillance de la figure 4 dans différents cas de figure.

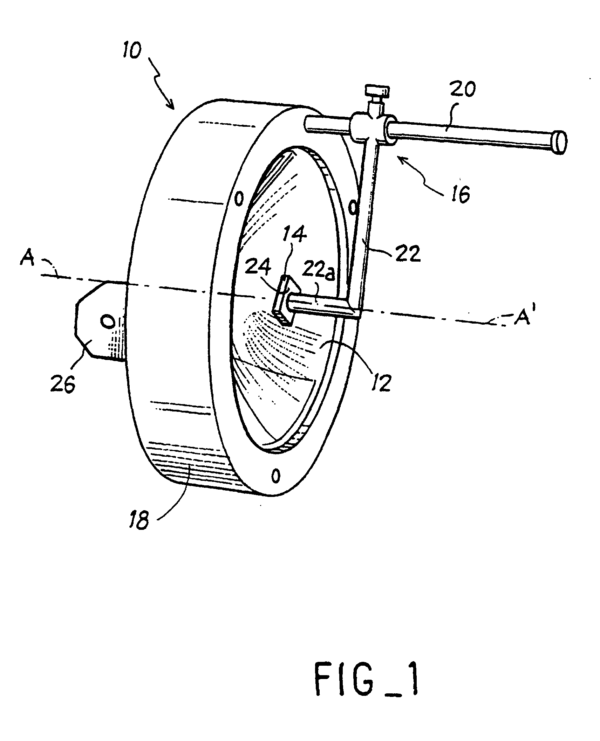

La figure 1 montre un ensemble de détection 10 composé d'un réflecteur parabolique 12 et d'un détecteur de rayonnement thermique 14. Le détecteur présente une surface active maintenue en regard du réflecteur grâce à une structure de support 16. Le réflecteur 12 est maintenu solidement autour de sa circonférence par un carter 18. La structure de support comprend une première tige 20 solidarisée à une extrémité au carter et s'étendant parallèlement à l'axe principal A-A' du réflecteur 12 dans le sens de son évasement.

Une deuxième tige 22 est montée coulissante sur la première tige 20 et en équerre par rapport à celle-ci. Cette deuxième tige 22 est terminée, vers son extrémité libre, par une portion en équerre 22a alignée avec l'axe A-A' principal du réflecteur 12. L'extrémité libre de la portion 22a de cette deuxième tige 22 présente une surface de support 24 pour le détecteur 14, permettant ainsi de positionner ce dernier à un point déterminé relativement au réflecteur - par exemple son foyer - par coulissement de la deuxième tige 22 le long de la première tige 20.

L'ensemble de détection se fixe sur un socle grâce à des pattes de fixation 26 qui dépendent du carter 18.

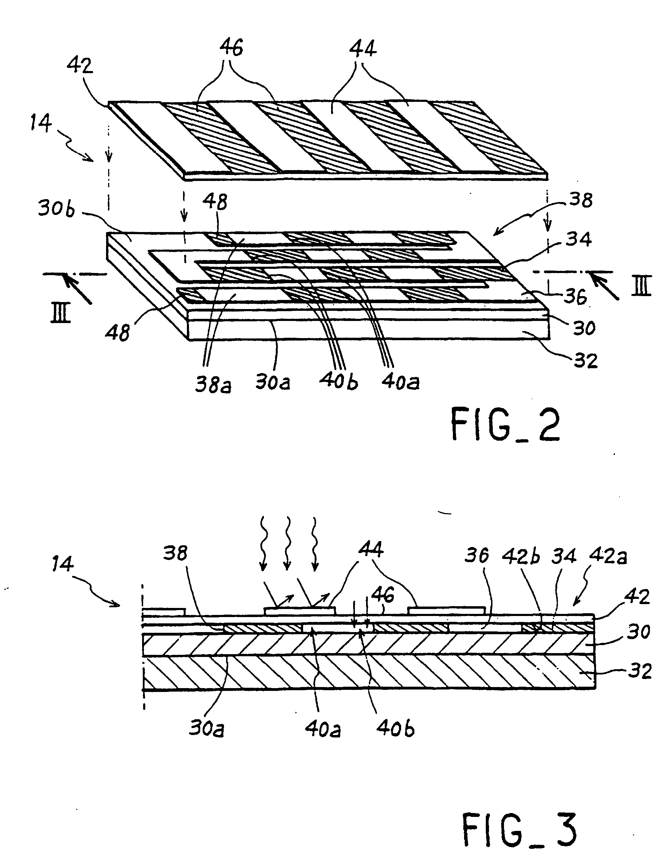

Les figures 2 et 3 montrent en détail le détecteur de rayonnement thermique 14 utilisé dans l'ensemble de détection mais sous forme simplifiée, notamment en ce qui concerne le nombre d'éléments actifs. Le détecteur 14 comprend un substrat 30 en matériau souple, tel que du "Kapton", d'une épaisseur comprise sensiblement entre 20 et 60 micromètres. La surface 30a du substrat destinée à être tournée vers le support de détecteur 24 comporte un dépôt de matériau isotherme 32, par exemple un métal tel que du cuivre, d'une épaisseur comprise sensiblement entre 20 et 100 micromètres.

L'autre surface 30b du substrat 30 comporte une succession d'éléments thermocouples 34, 36 formant une piste continue 38. La piste est configurée sous la forme de plusieurs lignes principales parallèles d'environ 5 mm de long et 0,5 mm de large, reliées aux extrémités de manière à former un chemin continu en méandres d'une extrémité à l'autre de la piste. La piste 38 est constituée par un dépôt de constantan revêtu de cuivre sur de courtes portions 38a successives discontinues. Chaque interface cuivre/constantan à la surface de la piste 38 crée une jonction de thermocouple 40a, 40b planaire.

La configuration des lignes parallèles principales de la piste 38 est telle que les jonctions de thermocouple 40a, 40b sont disposées en rangées perpendiculaires aux lignes principales de celle-ci.

La piste 38 est recouverte d'un film 42 d'une épaisseur de 5 à 25 micromètres en matériau sensiblement transparent au rayonnement thermique et électriquement isolant, tel que du Kapton. La surface 42a de ce film opposée à celle, 42b, en contact avec la piste 38 (figure 3), constitue la surface active du détecteur. Elle a pour fonction de créer, en réponse au rayonnement thermique, des aires froides et chaudes en alternance au-dessus des jonctions de thermocouple 40a, 40b successives le long de la piste 38.

A cette fin, le film 42 est revêtu, sur des portions de surface au-dessus des jonctions destinées à définir des jonctions froides 40a, d'un dépôt en matériau réfléchissant 44, par exemple une couche d'or d'une épaisseur comprise entre 0,1 et 5 micromètres. Ainsi, le matériau réfléchissant 44 comprend une série de bandes recouvrant des rangées alternées de jonctions. Les surfaces 46 du film 42 non revêtues de matériau réfléchissant 44 constituent les portions de surface absorbantes, situées de manière complémentaire au-dessus des jonctions destinées à définir des jonctions chaudes 40b. Ces portions de surface 46 peuvent être éventuellement recouvertes d'un matériau à forte absorption du rayonnement thermique, tel qu'une peinture noire. Eventuellement, pour une surface active 42a plus absorbante, le film peut être réalisé en Kapton du type "spécial corps noir", commercialisé par la société DuPont de Nemours.

Lorsque la surface active 42a du détecteur 14 reçoit un rayonnement thermique du à l'apparition d'une source de chaleur, telle qu'une personne, les parties 46 du film 42 non revêtues du matériau réfléchissant 44 subissent une augmentation de température plus importante que les parties revêtues de matériau réfléchissant. Il se forme ainsi un différentiel de température à la surface active du détecteur, qui sera transmis aux éléments 34, 36 de jonction thermocouple sous-jacents. Ainsi, on obtient une alternance de jonctions froides et chaudes 40a, 40b le long de la piste 38 de jonctions. Chaque paire de jonctions froide et chaude adjacentes 40a, 40b produit une force électromotrice selon l'effet Seebeck. On obtient alors une succession de piles élémentaires en série le long de la piste 38, délivrant un signal de détection sous forme de différence de potentiel entre les deux extrémités de la piste 38. Des contacts ohmiques 48 soudés à ces deux extrémités permettent de recueillir le signal de détection. Ce signal est proportionnel au différentiel de température créé en réponse au rayonnement thermique concentré par le réflecteur 12 sur la surface active du détecteur 14. Il est donc représentatif du flux thermique reçu sur la surface active 42a du détecteur 14.

Le détecteur 14 peut être réalisé aisément par l'homme de métier selon la technologie des circuits imprimés. Le dispositif est extrêmement plat, l'épaisseur étant inférieure à 0,2 mm, de format rectangulaire ou carré, ou encore circulaire, sur une aire typiquement comprise entre 0,25 et 1 cm². Il comporte typiquement 150 à 200 jonctions thermoélectriques en série, mais la technologie de fabrication permet de réaliser un bien plus grand nombre de jonctions sur un même substrat.

Un détecteur du type décrit offre une sensibilité typique entre 1,5 et 2,0 microVm²/W et présente une résistance électrique interne très faible, de l'ordre de 200 Ohms. Cette dernière caractéristique autorise une amplification importante du signal, d'un facteur de 1 000 à 10 000, voire plus selon l'application, sans être gêné par son bruit propre.

En mode de détection de radiation, le détecteur présente une constante de temps de l'ordre 100 ms.

La technologie de fabrication et le choix des matériaux constitutifs du détecteur permettent une utilisation à des températures ambiantes allant jusqu'à 250°C par contact.

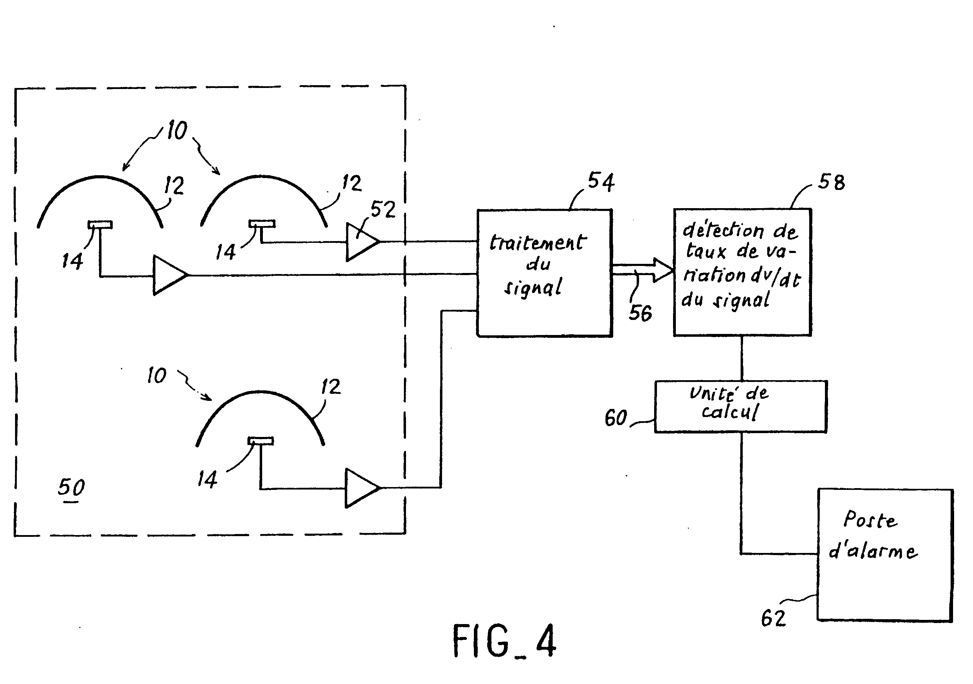

La figure 4 est un schéma de principe d'un exemple de système de surveillance réalisé à partir de l'ensemble de détection 10 de la figure 1.

Dans l'exemple, plusieurs ensembles de détection de rayonnement thermique 10 sont installés dans un local 50, tel qu'un entrepôt. Chaque ensemble a un champ de détection bien défini qui correspond à une zone de surveillance spécifique. Le champ de détection est adapté à la zone de surveillance requise en jouant sur l'un ou plusieurs des paramètres suivants : la forme du réflecteur 12, la taille de ce dernier, la distance entre l'ensemble de détection et la base de la zone de surveillance, l'orientation du réflecteur dans la zone de surveillance, et éventuellement la position de la surface sensible du détecteur 14 relativement à son réflecteur 12. Dans le cas d'un réflecteur parabolique de dimension compacte, on obtient un champ de détection relativement uniforme sur un volume conique autour du détecteur. La base du cône, qui définit la surface de détection, peut être aisément modulée pour obtenir des contours circulaires ou ovales de différentes dimensions en jouant uniquement sur la distance et l'orientation du réflecteur relativement à cette surface de détection.

Le signal de sortie de chaque ensemble de détection est transmis à un étage de préamplification respectif 52 dont le gain est réglable sur une plage comprise entre environ 100 à 10 000. Le signal préamplifié peut être éventuellement traité par des unités de filtrage, d'écrêtage ou de numérisation (représentées globalement par le repère 54) selon la nature de la surveillance.

Les signaux après préamplification et traitement éventuel sont recueillis sur des voies respectives 56 d'un détecteur 58 de taux de variation d'amplitude (dV/dt) du signal. Le détecteur est associé à une unité de calcul 60 programmée pour permettre d'identifier les formes de signaux analysés correspondant à une intrusion. Lorsque l'une de ces conditions est détectée, l'unité de calcul 60 envoie un signal de détection vers un poste d'alarme 62, éventuellement avec des données indicatives de la zone concernée et de la nature de l'intrusion.

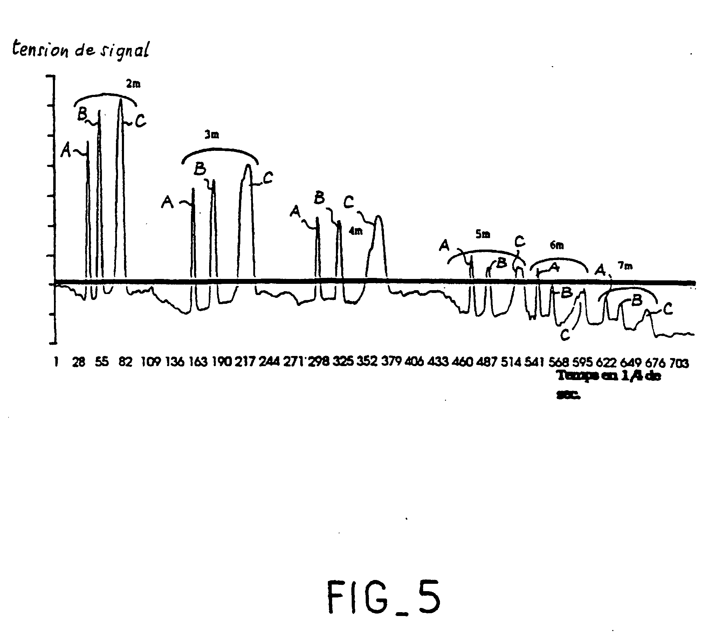

La figure 5 est un exemple de relevé, sous forme de graphe, de signaux recueillis par l'ensemble de détection selon la figure 1 installé dans un couloir surveillé. L'ordonnée représente la grandeur du signal de sortie, exprimée en valeurs relatives, et l'abscisse représente l'échelle de temps.

En situation de repos, le détecteur émet un signal de plancher présentant des fluctuations relativement faibles. Lors d'une intrusion par une présence humaine, on obtient un pic de forte amplitude.

Dans l'exemple, le relevé montre des pics de détection respectifs pour une personne pénétrant dans la zone de détection en effectuant un saut (pic A), un passage normal (pic B) et une entrée sur la pointe des pieds (pic C).

Ces pics A-C sont présentés pour des distances entre la personne et le foyer de la zone allant de deux à sept mètres, comme indiqué sur la figure.

On remarque que le signal obtenu est aisément détectable dans tous ces cas de figure, grâce notamment au temps de réponse rapide de détecteur et à la très grande sensibilité autorisée par la combinaison du capteur et de son concentrateur du type à réflexion. Il est possible d'envisager une discrimination du signal au niveau de l'unité de calcul 60 permettant d'informer sur le déplacement dans l'espace et dans le temps dans la zone surveillée, ainsi que le nombre de personnes présentes.

Le système de détection fournit un signal de détection causé par une modification, au niveau du détecteur 14, du bilan thermique entre le rayonnement reçu et le rayonnement ré-émis. La présence d'un intrus dans le champ de détection constitue une modification de la cartographie thermique de la zone surveillée, soit par le fait d'un apport en chaleur (cas le plus probable), soit par le masquage d'une source de chaleur, ce qui peut être le cas dans un site industriel. Etant donné qu'il est quasiment impossible de connaître la température de chaque point de la surface cachée par l'intrus, et que la température de l'intrus doit être égale à la température moyenne de la surface qu'il cache afin que le bilan thermique reste stable, il est extrêmement difficile de frauder un système de surveillance basé sur des dispositifs conformes à la présente invention.

L'invention se prête à de nombreuse variantes tant au niveau du détecteur de rayonnement thermique qu'au niveau du concentrateur.

Le concentrateur peut être de forme complexe, étudiée pour que le champ de détection soit calqué sur un périmètre de contour spécifique. On peut notamment utiliser à cette fin des outils de conception assistée par ordinateur fonctionnant sur des logiciels d'analyse de tracés de rayons optiques.

## Revendications

1. Dispositif (10) de détection de rayonnement thermique **caractérisé en ce qu'**il comprend:
un détecteur (14) ayant un substrat (30) qui comporte, sur une première face (30b), une ou plusieurs jonctions de thermocouple dites "chaudes" (40b) destinées à être exposées au rayonnement thermique et une ou plusieurs jonctions de thermocouple dites "froides" (40a) destinées à être protégées du rayonnement thermique, le détecteur étant sensible à une différence de température entre jonctions chaudes et froides, et
un concentrateur du type réflecteur (12), associé audit détecteur pour concentrer sur celui-ci le rayonnement thermique émanant d'une zone spatiale prédéterminée,
et **en ce que** la deuxième face (30a) du substrat, opposée à la première face, est en contact avec une couche de matériau isotherme (32), s'étendant en regard des jonctions chaudes et froides.

2. Dispositif selon la revendication 1, **caractérisé en ce qu'**il comprend en outre un détecteur de variation d'amplitude (dV/dt) du signal recueilli par le détecteur, et destiné à fournir un signal de détection dudit dispositif.

3. Dispositif (10) selon la revendication 2, **caractérisé en ce qu'**il comprend en outre un moyen d'analyse de la forme du signal issu du détecteur de variation d'amplitude.

4. Dispositif selon l'une quelconque des revendications 1 à 3, **caractérisé en ce que** ledit détecteur (14) est composé d'au moins une paire d'éléments thermocouple planaires (34, 36) ayant lesdites jonction(s) chaude(s) et jonction(s) froide(s).

5. Dispositif selon l'une quelconque des revendications 1 à 4, **caractérisé en ce que** le détecteur (14) comprend en outre des éléments de surface sensiblement absorbants (46) sur les jonctions chaudes (40b) et des éléments de surface sensiblement réflechissants (44) sur les jonctions froides (40a).

6. Dispositif selon la revendication 5, **caractérisé en ce que** ledit détecteur (14) comprend une pluralité de paires d'éléments thermocouples (34, 36) montés en série et disposés en plusieurs lignes reliées aux extrémités de manière à former une piste en méandres (38), les jonctions froides et chaudes (40a, 40b) étant disposées en rangées alternées respectives disposées transversalement aux lignes et étant en contact thermique avec un film (42) comportant des bandes réfléchissantes (44) et absorbantes (46) arrangées en rangées alternées en phase et alignées respectivement avec les jonctions froides (40a) et chaudes (40b).

7. Dispositif selon les revendications 5 ou 6, **caractérisé en ce que** lesdites paires d'éléments thermocouples (34, 36) sont réalisées par des éléments alternés de cuivre et de constantan déposés sur le substrat (30) en matériau électriquement isolant et d'absorption thermique élevée, et **en ce que** lesdits éléments thermocouples sont recouverts d'un matériau (42) présentant une absorption thermique élevée, les portions dudit matériau recouvrant une jonction froide (40a) étant revêtues d'une couche de matériau réfléchissant (44).

8. Dispositif selon la revendication 7, **caractérisé en ce que** ledit substrat (30) est en Kapton et **en ce que** ledit matériau (42) recouvrant les paires d'éléments thermocouples (34, 36) est en Kapton recouvert d'or aux portions de surface réfléchissantes (44).

9. Dispositif selon l'une quelconque des revendications 1 à 8, **caractérisé en ce que** ladite couche de matériau isotherme est une couche métallique (32).

10. Dispositif selon l'une quelconque des revendications 1 à 9, **caractérisé en ce que** le réflecteur (12) est du type parabolique.

11. Dispositif selon l'une quelconque des revendications 1 à 10, **caractérisé en ce qu'**il comprend un support (16) pour ledit détecteur (14) monté mobile le long d'un axe (A-A') déterminé relativement audit réflecteur.

12. Appareil de détection de présence comprenant au moins un dispositif de détection de rayonnement thermique (10) selon l'une quelconque des revendications 1 à 11, et un moyen de contrôle (54, 60) recevant le ou les signaux de détection et émettant un signal indicatif d'une présence en fonction du ou des signaux de détection.

## Claims

1. Heat radiation device (10), **characterised in that** it includes :
a detector (14) having a substrate (30) which comprises on a first face (30b) one or several "hot" thermocouple junction points (40b) intended to be exposed to the heat radiation and one or several "cold" thermocouple junction points (40a) intended to be protected from the heat radiation, the detector being sensitive to a temperature difference between hot and cold junction points, and
a reflector type concentrator (12) associated with said detector so as to concentrate on the latter the heat radiation emanating from a predetermined spatial zone,
and **in that** the second face (30a) of the substrate opposite the first face is in contact with a layer made of an isothermal material (32) extending opposite the hot and cold junction points.

2. Device according to claim 1, **characterised in that** it further includes an amplitude variation detector (dV/dt) concerning the signal picked up by the detector and intended to provide a detection signal of said device.

3. Device (10) according to claim 2, **characterised in that** it further includes an element for analysing the shape of the signal derived from the amplitude variation detector.

4. Device according to one of claims 1 to 3, **characterised in that** said detector (14) is composed of at least one pair of planar thermocouple elements (34, 36) having said hot and hot junction points.

5. Device according to one of claims 1 to 4, **characterised in that** the detector (14) further includes approximately absorbent surface elements (46) on the hot junction points (40b) and approximately reflecting surface elements (44) on the cold junction points (40a).

6. Device according to claim 5, **characterised in that** said detector (14) includes a plurality of pairs of thermocouple elements (34, 36) mounted in series and placed in several lines connected to the extremities so as to form a meanders track (38), the cold and hot junction points (40a, 40b) being placed in respective alternate rows placed transversally to the lines and being in heat contact with a film (42) comprising reflecting (44) and absorbent (46) strips arranged in alternate rows in phase and respectively aligned with the cold (40a) and hot (40b) junction points.

7. Device according to claim 5 or 6, **characterised in that** said pairs of thermocouple elements (34, 36) are embodied by alternate copper and constantan elements placed on the substrate (30) made of an electrically nonconducting material having a high rate of heat absorption, and **in that** said thermocouple elements are covered with a material (42) possessing high heat absorption, the portions of said material covering a cold junction point (40a) being coated with a layer of a reflecting material (44).

8. Device according to claim 7, **characterised in that** said substrate (30) is made of Kapton and **in that** said material (42) covering the pairs of thermocouple elements (34, 36) is made of Kapton coated with gold at the reflecting surface portions (44).

9. Device according to one of claims 1 to 8, **characterised in that** said isothermal layer is a metal layer (32).

10. Device according to one of claims 1 to 9, **characterised in that** the reflector (12) is of the parabolic type.

11. Device according to one of claims 1 to 10, **characterised in that** it includes a support (16) for said detector (14) mounted mobile along a specific axis (A-A') in relation to said reflector.

12. Presence detection device including at least one heat radiation device (10) according to one of claims 1 to 11, and a control element (54, 60) receiving the detection signal(s) and emitting a signal indicating a presence according to the detection signal(s).

## Patentansprüche

1. Vorrichtung zum Detektieren von Wärmestrahlung,
**dadurch gekennzeichnet,**
**dass** sie umfasst:
einen Detektor (14) mit einem Substrat (30), welches auf einer ersten Seite (30b) ein oder mehrere Thermopaarverbindungen, als "heiße" (40b) bezeichnet, aufweist, die dazu dienen, einer Wärmestrahlung ausgesetzt zu werden, und ein oder mehrere Thermopaaverbindungen, als "kalte" (40b) bezeichnet, aufweist, die dazu dienen, von der Wärmestrahlung geschützt zu werden, wobei der Detektor auf eine Temperaturdifferenz zwischen heißen und kalten Verbindungen anspricht, und
einen Konzentrator vom Reflektortyp (12) welcher dem Detektor zugeordnet ist, um auf diesen die Wärmestrahlung zu konzentrieren, die aus einer vorbestimmten Raumzone kommt,
und **dass** die zweite Seite (30a) des Substrats, die der ersten Seite abgewandt ist, sich in Berührung mit einer isothermen Materialschicht (32) befindet, die sich gegenüber den heißen und kalten Verbindungen erstreckt.

2. Vorrichtung nach Anspruch 1,
**dadurch gekennzeichnet,**
**dass** sie außerdem einen Detektor für Amplitudenänderung (dV/dt) des von dem Detektor erfassten Signals aufweist, der dazu ausgelegt ist, ein Detektorsignal der Vorrichtung zu liefern.

3. Vorrichtung (10) nach Anspruch 1,
**dadurch gekennzeichnet,**
**dass** sie außerdem eine Analyseeinrichtung für das von dem Amplitudenänderungsdetektor ausgegebene Signal aufweist.

4. Vorrichtung nach einem der Ansprüche 1 bis 3,
**dadurch gekennzeichnet,**
**dass** der Detektor (14) sich aus mindestens einem Paar planarer Thermopaarelemente (34, 36) zusammensetzt, welche die eine oder die mehreren heißen und kalten Verbindungen aufweisen.

5. Vorrichtung nach einem der Ansprüche 1 bis 4,
**dadurch gekennzeichnet,**
**dass** der Detektor (14) außerdem auf den heißen Verbindungen (40b) im Wesentlichen absorbierende Oberflächenelemente aufweist, und auf den kalten Verbindungen (40a) im Wesentlichen reflektierende Oberflächenelemente (44) aufweist.

6. Vorrichtung nach Anspruch 5,
**dadurch gekennzeichnet,**
**dass** der Detektor (14) außerdem eine Mehrzahl von Thermopaarelementen (34, 36) aufweist, die in Reihe und in mehreren Linien angeordnet sind, welche an ihren Enden derart miteinander verbunden sind, dass sie eine Mäanderbahn (38) bilden, wobei die kalten und die heißen Verbindungen (40a, 40b) an alternierenden Plätzen in Querrichtung der Linien angeordnet sind und sich in Wärmekontakt mit einem Film (42) zu befinden, der reflektierende Bänder (44) und absorbierende Bänder (46) trägt, die an alternierenden Phasenplätzen angeordnet sind und mit den kalten Verbindungen (40a) bzw. heißen Verbindungen (40b) fluchten.

7. Vorrichtung nach Anspruch 5 oder 6,
**dadurch gekennzeichnet,**
**dass** die paarweisen Elemente von Thermopaaren (34, 36) durch abwechselnde Elemente aus Kupfer und Konstantan gebildet sind, angeordnet auf dem Substrat (30) aus elektrisch isolierendem und thermisch stark absorbierendem Material, und dass die Thermopaarelemente mit einem Material (42) bedeckt sind, welches eine erhöhte Wärmeabsorption aufweist, wobei die Materialbereiche, die eine kalte Verbindung (40a) bedecken,mit einer reflektierenden Materialschicht (44) bedeckt sind.

8. Vorrichtung nach Anspruch 7,
**dadurch gekennzeichnet,**
**dass** das Substrat (30) aus Kapton besteht und dass das die paarweisen Thermopaarelemente (34, 36) bedeckende Material (42) aus Kapton besteht und an den reflektierenden Oberflächenbereichen (44) mit Gold bedeckt ist.

9. Vorrichtung nach einem der Ansprüche 1 bis 8,
**dadurch gekennzeichnet,**
**dass** die isotherme Materialschicht eine Metallschicht (32) ist.

10. Vorrichtung nach einem der Ansprüche 1 bis 9,
**dadurch gekennzeichnet,**
**dass** der Reflektor (12) parabolisch ausgebildet ist.

11. Vorrichtung nach einem der Ansprüche 1 bis 10,
**dadurch gekennzeichnet,**
**dass** sie einen Träger (16) für den Detektor (14) aufweist, der entlang einer in Bezug auf den Reflektor festgelegten Achse (A - A') beweglich gelagert ist.

12. Anwesenheitsdetektor-Vorrichtung mit mindestens einer Vorrichtung zum Detektieren von Wärmestrahlung (10) nach einem der Ansprüche 1 bis 11, und mit einer Steuereinrichtung (54, 60), die das Detektorsignal oder die Detektorsignale empfängt und ein als Funktion des oder der Detektorsignale für ein Vorhandensein kennzeichnendes Signal abgibt.
